# EUROPÄISCHE PATENTANMELDUNG

(11) **EP 1 398 828 A2**
(43) Veröffentlichungstag der Anmeldung: **17.03.2004**
(21) Anmeldenummer: 03017505.3
(22) Anmeldetag: 04.08.2003
(51) Int. Cl.: H01L 21/56

(54) **Halbleitergehäuse mit vorvernetzten Kunststoffeinbettmassen und Verfahren zur Herstellung desselben**

(30) Priorität: 29.08.2002 DE 10240460
(71) Anmelder: Infineon Technologies AG, 81669 München (DE)
(72) Erfinder: Goller, Bernd, 83624 Otterfing (DE); Stümpfl, Christian, 92421 Schwandorf (DE); Hagen, Robert-Christian, 93092 Sarching (DE); Wein, Stefan, 93138 Lappersdorf (DE); Ofner, Gerald, 93077 Bad Abbach (DE); Wörner, Holger, 93049 Regensburg (DE)
(74) Vertreter: Schweiger, Martin

(57) **Zusammenfassung**

Universelles Halbleitergehäuse mit vorvernetzten Kunststoffeinbettmassen und Verfahren zur Herstellung desselben.

Die Erfindung betrifft ein elektronisches Bauteil (2) und einen Nutzen (1) die Kunststoffeinbettmassen einer ersten und einer zweiten Kunststoffschicht aufweisen, sowie ein Verfahren zu deren Herstellung. In der ersten Kunststoffschicht (7) sind Halbleiterchips (5) derart eingebettet, daß ihre Randseiten (18) von einem Wulst (10) umgeben sind. Die zweite Kunststoffschicht (11) gleicht die Unebenheiten einer obenseitigen Grenzschicht (13) der ersten Kunststoffschicht (7) aus.

## Beschreibung

Universelles Halbleitergehäuse mit vorvernetzten Kunststoffeinbettmassen und Verfahren zur Herstellung desselben.

Die Erfindung betrifft eine Technologie zur Herstellung von universellen Halbleitergehäusen unter Verwendung vorvernetzter Kunststoffeinbettmassen. Insbesondere betrifft die Erfindung ein Verfahren zur Herstellung eines Nutzens mit mehreren Bauteilpositionen für elektronische Bauteile, der derartige Kunststoffeinbettmassen aufweisen, sowie elektronische Bauteile mit entsprechenden Kunststoffeinbettmassen.

Aus der Druckschrift US 5,990,546 ist ein elektronisches Bauteil mit einem Halbleiterchip bekannt, bei dem der Halbleiterchip in einer Kunststoffeinbettmasse eingeschlossen ist und Kontaktbereiche des Halbleiterchips über eine separat bereitgestellte Umverdrahtungsplatte mit Außenkontakten des elektronischen Bauteils elektrisch verbunden sind. Das Bereitstellen einer separaten, komplex aufgebauten Umverdrahtungsplatte für einen Zusammenbau eines elektronischen Bauteils ist kostenintensiv. Außerdem tritt beim Herstellen derartiger elektronischer Bauteile das Problem auf, dass ein Verbinden der Kontaktbereiche der Halbleiterchips mit entsprechenden Kontaktanschlussflächen der separat bereitgestellten Umverdrahtungsplatte äußerst schwierig ist und dass hohe Ausschussraten bei einem derartigen Verfahren auftreten. Darüber hinaus ist die Zuverlässigkeit derartige elektronischer Bauteile begrenzt.

Aufgabe der Erfindung ist es, ein Verfahren anzugeben, mit dem zuverlässige Verbindungen zwischen einem Halbleiterchip und Außenkontakten eines elektronischen Bauteils erreicht werden, und die Ausbeute bei der Herstellung elektronischer Bauteile verbessert ist, sowie die Kosten der Herstellung elektronischer Bauteile vermindert sind.

Gemäß der Erfindung wird ein Verfahren zur Herstellung eines Nutzens mit mehreren Bauteilpositionen für elektronische Bauteile angegeben. Dabei bildet der Nutzen eine selbsttragende formstabile Kunststoffplatte aus Kunststoffeinbettmaterialien. In jeder der Bauteilpositionen ist ein Halbleiterchip in die Kunststoffplatte eingebettet. Auf dieser selbsttragende formstabile Kunststoffplatte können dann unmittelbar Umverdrahtungsstrukturen lagenweise aufgebracht werden, so dass mit diesem Verfahren das Herstellen einer separaten komplexen Umverdrahtungsplatte entfällt und die Probleme eines Verbindens von Kontaktflächen einer Umverdrahtungsplatte mit den Kontaktbereichen eines Halbleiterchips überwunden werden, da bei dem erfindungsgemäßen Verfahren keine Umverdrahtungsplatte mit Halbleiterchips bestückt werden muss.

Das Verfahren zur Herstellung eines derartigen Nutzens auf dem abschließend für mehrere elektronische Bauteile gleichzeitig Umverdrahtungslagen unmittelbar abgeschieden werden können, weist im wesentlichen 4 Verfahrensschritte auf. Zunächst wird eine Trägerplatte und/oder eine erste Kunststoffschicht aus einer Kunststoffeinbettmasse bereitgestellt, wobei die erste Kunststoffschicht in einem unteren Bereich stärker vorvernetzt ist als in einem oberen Bereich. Der Vernetzungsgrad in dem unteren Bereich kann derart hoch sein, dass der untere Bereich bereits eine selbsttragende formstabile Kunststoffschicht ausbildet, so daß der untere Bereich der ersten Kunststoffschicht bereits die Trägerplatte ersetzt.

Auf eine derartige Trägerplatte und/oder eine derartige erste Kunststoffschicht wird dann in der jeweiligen Bauteilposition ein Halbleiterchip unter Bilden eines die Randseiten des Halbleiterchips umgebenden Wulstes aus Kunststoffeinbettmasse aufgebracht. Anschließend wird eine zweite Kunststoffschicht aufgebracht, die mindestens die Randseiten des Halbleiterchips vollständig eingebettet. Danach wird durch Aushärten der Kunststoffschichten eine selbsttragende formstabile Kunststoffplatte mit eingebetteten Halbleiterchips gebildet. Das Aushärten der Kunststoffschichten kann durch thermische Behandlung und/oder durch Bestrahlen mit hochenergetischen Lichtstrahlen, wie mit ultraviolettem Licht beschleunigt werden.

Die Kunststoffeinbettmasse der selbstragenden formstabilen Kunststoffplatte kann zusätzlich zu den beiden Kunststoffschichten weitere Kunststoffschichten aufweisen. So können faserverstärkte oder mit Glaskugeln gefüllte Kunststoffschichten vorgesehen sein, um eine selbsttragende formstabile Kunststoffplatte mit eingebetteten Halbleiterchips zu verwirklichen.

Dieses Verfahren hat den Vorteil, dass ein expandierter Wafer in Form eines Nutzens gebildet wird, auf dem für mehrere Bauteile gleichzeitig in einem Parallelverfahren Umverdrahtungsstrukturen aus Umverdrahtungslagen mit Kontaktanschlußflächen, Umverdrahtungsleitungen und Außenkontaktflächen aufgebracht werden können. Dazu wird in jeder Bauteilposition eine Umverdrahtungsstruktur auf die selbsttragende formstabile Kunststoffplatte aufgebracht, die mit den Kontaktbereichen des Halbleiterchips elektrisch verbunden ist.

In diesem Zusammenhang werden unter Kontaktbereichen des Halbleiterchips die unmittelbar auf den Halbleiterchips angeordneten Kontaktflächen verstanden und darüber hinaus auch Flipchip-Kontakte, die auf diesen Kontaktflächen angeordnet sind. Als Flipchip-Kontakte kann der Halbleiterchip Lötbälle aufweisen, die auf die Kontaktflächen des Halbleiterchips gelötete Lötkugeln darstellen. Darüber hinaus können Flipchip-Kontakte als Löthöcker ausgebildet sein, die auf den Kontaktflächen eines Halbleiterchips durch Drucktechnik mit anschließendem Sinterverfahren hergestellt sind. Die Flipchip-Kontakte eines Halbleiterchips können auch als Flächenkontakte ausgebildet sein, wobei die Kontaktflächen der Halbleiterchips beispielsweise durch ein lötbares Material vergrößert und verdickt sind. Auch Kopfkontakte sind als Flipchip-Kontakte möglich, die einen Thermokompressionskopf aufweisen und als "stud bumps" bekannt sind. Darüber hinaus können Flipchip-Kontakte als überhöhte Anschlussflächen durch galvanische oder chemische Abscheidung eines Metalls auf den Kontaktflächen als Säulenkontakte dargestellt sein.

Wenn auch die Kontaktbereiche des Halbleiterchips unterschiedliche Formen und Strukturen aufweisen, können sie dennoch zuverlässig mit Umverdrahtungsstrukturen aufgrund des erfindungsgemäßen Verfahrens verbunden werden. Sind die Kontaktbereiche der Halbleiterchips durch eine Trägerplatte oder durch eine der Kunststoffschichten teilweise oder vollständig abgedeckt, so können die Kontaktbereiche durch einen photolithographischen Schritt vor einem Aufbringen von Umverdrahtungsstrukturen freigelegt werden.

Zum Herstellen einer Trägerplatte wird eine Grundplatte auf Temperaturen zwischen 120 und 350 °C aufgeheizt. Diese aufgeheizte Grundplatte kann mit einer ersten Kunststoffschicht aus einer Kunststoffeinbettmasse beschichtet sein. Beim Abkühlen der Kunststoffeinbettmasse auf der Trägerplatte bildet sich höhengestaffelt zu einer obenseitigen Grenzfläche der ersten Kunststoffschicht hin ein abnehmender Vernetzungsgrad aus. Ein unterer heißerer Bereich der ersten Kunststoffschicht, der unmittelbar die aufgeheizte Grundplatte berührt, wird beim Abkühlen stärker vernetzt als der Bereich zu der Oberseite der ersten Kunststoffschicht hin. Die aufheizbare Grundplatte kann dazu eine Metalllegierung aufweisen. Diese Verfahrensvariante hat den Vorteil, dass eine metallische Grundplatte nach Aushärten der Kunststoffeinbettmassen des Nutzens von der entstandenen formstabile und selbsttragende Kunststoffplatte abgezogen werden kann.

Zur Herstellung einer Vollkunststoff-Trägerplatte kann eine erste Kunststoffschicht einer unvernetzten Kunststoffeinbettmasse einem derartigen Temperaturgradienten ausgesetzt werden, dass in dem Bereich der Unterseite der ersten Kunststoffschicht ein vollständig vernetzter, selbsttragender, formstabiler unterer Bereich gebildet wird, während darüber ein mit der Höhe der Kunststoffschicht abnehmender Vernetzungsgrad auftritt. Diese Variante der Trägerplatte hat den Vorteil, dass Halbleiterchips mit ihrer passiven Rückseite in den oberen nur vorvernetzten Bereich eingedrückt und in dieser Position fixiert werden können, wobei die Eindringtiefe durch den vollständig vernetzten Bereich vorgegeben wird. Außerdem ist dann sichergestellt, dass die aktive Oberseite des Halbleiterchips mit den Kontaktbereichen nicht von dem Kunststoffeinbettmaterial der ersten Kunststoffschicht benetzt wird. Es wird vielmehr unter Bildung eines Wulstes rundum den Halbleiterchip herum ein Teil der Randseitenhöhe des Halbleiterchips von der Kunststoffeinbettmasse der ersten Kunststoffschicht benetzt.

Für die Herstellung der ersten Kunststoffschicht kann eine unvernetzte Kunststoffeinbettmasse mit kugelförmigen Partikeln von einheitlichem Kugeldurchmesser gefüllt werden. Dazu eignen sich insbesondere Glaskugeln, die mit äußerst kleinem Durchmesser in der Größenordnung von wenigen 100 Nanometern mit einem Sprühverfahren hergestellt werden können. Diese Verfahrensvariante hat den Vorteil, dass in die mit kugelförmigen Partikeln gefüllte erste Kunststoffschicht ein Halbleiterchip eingedrückt werden kann, wobei die Eindringtiefe durch den einheitlichen Kugeldurchmesser definiert wird.

Während bei den bisher beschriebenen Varianten des Verfahrens der Halbleiterchip mit seiner passiven Rückseite in den oberen lediglich vorvernetzten Bereich der ersten Kunststoffschicht eingebracht wird, kann der Halbleiterchip jeweils in einer Bauteilposition des Nutzens mit seiner aktiven Oberseite und seinen Kontaktbereichen in die erste Kunststoffschicht unter Bilden eines die Randseiten des Halbleiterchips umgebenden Wulstes eingedrückt werden. Bei dieser Verfahrensvariante ist der Vernetzungsgrad des unteren Bereichs der ersten Kunststoffschicht nicht derart weit fortgeschritten, dass sich ein vollständig vernetzter unterer Bereich ausgebildet hat, sondern der Vorvernetzungsgrad ist noch derart, daß die Kontaktbereiche eine Trägerplatte oder eine Trägerfolie aus Metall berühren können. Da nun die passive Rückseite der Halbleiterchips an den Bauteilpositionen des Nutzens aus der ersten Kunststoffschicht herausragen, können diese Rückseiten anschließend von der zweiten Kunststoffschicht bedeckt und geschützt werden.

Um die Kontaktbereiche freizulegenden wird anschließend lediglich die metallische Trägerplatte oder metallische Trägerfolie nach dem Aushärten der Kunststoffschichten abgezogen. Ein gesonderter Verfahrenschritt zum Freilegen der Kontaktbereiche der Halbleiterchips kann bei dieser Verfahrensvariante entfallen.

Wird der Halbleiterchip jeweils an den Bauteilpositionen des Nutzens in seiner passiven Rückseite zunächst in die erste Kunststoffschicht unter Bilden eines die Randseiten des Halbleiterchips umgebenden Wulstes aus Kunststoffeinbettmasse eingedrückt, so ragt die aktive Oberseite des Halbleiterchips mit den Kontaktbereichen aus der ersten Kunststoffschicht heraus.

Die Halbleiterchips können in dieser ersten Kunststoffschicht zu einem neuen expandierten Wafer angeordnet werden. Die Kunststoffeinbettmasse der ersten Kunststoffschicht wird auch als "bi-stage"- Material bezeichnet, da die Kunststoffeinbettmasse der ersten Kunststoffschicht mindestens zwei Bereiche mit unterschiedlichem Vernetzungsgrad aufweist. Derartige Kunststoffeinbettmassen sind teilverletzte duroplastische Kunststoffe, deren Vernetzungsprozess eingefroren oder unterbrochen ist. Bei dem Einfrieren dieses Zustandes sind die Materialien fest und formstabil, werden aber wieder bei Wärmeeinbringung durch Aufheizen auf Temperaturen zwischen 90 und 120 °C teilweise viskos, so dass Halbleiterchips platziert werden können.

Andererseits wird durch eine erneute Wärmezufuhr bei Temperaturen zwischen 120 und 350 °C der Aushärtemechanismus wieder in Gang gesetzt, so dass das Material dann vollständig vernetzten kann. Der Einsatz derartiger Materialsysteme für die erste Kunststoffschicht besteht darin, dass der Duroplast bereits auf einen Träger aufgebracht werden kann, ohne dort vollständig ausgehärtet zu werden. Wird dieses Material mit anderen noch nicht vernetzten Duroplasten in Kontakt gebracht, so ist auch eine chemisch-physikalisch Vernetzung über die Grenzfläche zwischen erster und zweiter Kunststoffschicht möglich. Somit kann eine hervorragende Haftung zwischen den beiden Materialien der ersten und der zweiten Kunststoffschicht erreicht werden.

Die zweite Kunststoffschicht kann derart auf die ersten Kunststoffschicht aufgebracht werden, daß entweder die gesamte aktive Oberseite eines Halbleiterchips von der zweiten Kunststoffschicht freigehalten wird oder das mindestens die Kontaktbereiche des Halbleiterchips frei von der zweiten Kunststoffschicht bleiben. Mit der zweiten Kunststoffschicht ist der Vorteil verbunden, dass die Oberseite des Nutzens eingeebnet wird, so dass eine ebene Fläche für ein Abscheiden von Umverdrahtungsstrukturen auf dem Nutzen zur Verfügung steht.

Das vollständige Aushärten der Kunststoffschichten kann entweder gleichzeitig für mehrere Kunststoffschichten oder nacheinander durchgeführt werden. Wird das Aushärten nacheinander durchgeführt, so ergibt sich bereits nach dem Aufbringen der Halbleiterchips in die erste Kunststoffschicht ein selbsttragender formstabiler Körper, der einfach und zuverlässig gehandhabt werden kann. Er kann sogar bis zum Auftragen der zweiten Kunststoffschicht zwischengelagert werden. Die zweite Kunststoffschicht kann dann mittels eines Transfermoldverfahrens oder mittels eines Schleudergussverfahrens aufgebracht werden. Während für das Transfermoldverfahren ein gefülltes Epoxidharz als zweite Kunststoffschicht zum Einebnen der Oberfläche des Nutzens auf die erste Kunststoffschicht aufgebracht wird, eignen sich für das Schleudergussverfahren insbesondere Kunststoffe auf Polyimid-Basis.

Zum Aushärten der zweiten Kunststoffschicht kann der Nutzen. auf 120 bis 350 °C für 2 bis 30 Minuten erwärmt werden. Auch wenn mehrere Kunststoffschichten gemeinsamen Aushärten ausgesetzt werden, kann mit diesem Temperatur- und Zeitintervall gearbeitet werden. Das Aushärten kann wesentlich verkürzt werden, wenn die Kunststoffschichten des Nutzens für einige Sekunden bis zu einigen Minuten mit UV-Licht bestrahlt werden.

Auf die ausgehärtete, freitragende und formstabile Kunststoffplatte, die nun der Nutzen darstellt, kann nach Freilegen der Kontaktbereiche der Halbleiterchips eine Umverdrahtungsstruktur auf den Nutzen aufgebracht werden. Die Umverdrahtungsstruktur weist Kontaktanschlussflächen auf, die auf den Kontaktbereichen der Halbleiterchips abgeschieden werden. Ferner weist die Umverdrahtungsstruktur Umverdrahtungsleitungen auf, die zu Positionen von Außenkontakten führen. Die Bildung einer derartigen Umverdrahtungsstruktur kann durch chemische oder galvanische Abscheidung eines Metalls erfolgen.

Eine galvanische Abscheidung der Umverdrahtungsstruktur auf der Oberseite des Nutzens mit freigelegten Kontaktbereichen kann vorteilhaft in drei Stufen erfolgen. Zunächst wird eine geschlossene Metallschicht mittels Sputtern bzw. Zerstäubungstechnik aufgebracht. Diese Metallschicht von wenigen Nanometern Dicke dient dazu, einen großflächigen elektrischen Kontakt für die galvanische Abscheidung auf der selbsttragende Kunststoffplatte des Nutzens zur Verfügung zustellen. Anschließend wird eine Photolackmaske unter Freilassung der gesputterten Schicht in einem Muster der Umverdrahtungsstruktur derart aufgebracht, dass Bereiche, die keine Umverdrahtungsstruktur aufweisen sollen von Photolack bedeckt sind. Anschließend wird galvanisch eine Metallegierung unter Bildung der Umverdrahtungsstruktur in einem Elektrolytbad abgeschieden. Nach der Bildung der metallischen Umverdrahtungsstruktur wird die Photolackbeschichtung entfernt. Abschließend wird die gesputterte Schicht, durch Ätzen der gesamten Oberfläche des Nutzens entfernt. Bei diesem Ätzvorgang wird die Umverdrahtungsstruktur nur geringfügig in ihrer Dicke vermindert. Durch das galvanische Aufbringen der Umverdrahtungsstruktur wird zuverlässig die Umverdrahtungsstruktur mit ihren Kontaktanschlussflachen mit den Kontaktbereichen der Halbleiterchips verbunden.

Bei einer chemischen Abscheidung einer Metallisierung als Umverdrahtungsstruktur kann auf eine Metallisierung der gesamten Oberfläche des Nutzens und damit beispielsweise auf den Sputterschritt verzichtet werden. Ein Vorteil der chemischen oder galvanischen Abscheidung der Umverdrahtungsstruktur liegt darin, daß für eine Vielzahl von elektronischen Bauteilen gleichzeitig Umverdrahtungsstrukturen auf dem Nutzen abgeschieden werden können.

Ein alternatives Verfahren zum Aufbringen der Umverdrahtungsstruktur besteht darin, entweder durch Strahldrucken auf dem Nutzen die Umverdrahtungsstruktur zu drucken oder durch eine Maske, wie beim Schablonendruckverfahren oder Siebdruckverfahren, eine Umverdrahtungsstruktur auf den Nutzen aufzubringen.

Auf der Kunststoffplatte können weitere Umverdrahtungslagen aufgebracht werden, indem im Wechsel Isolationslagen mit Durchkontakten und Isolationlagen mit Umverdrahtungsleitungen auf der ersten Umverdrahtungsstruktur angeordnet werden. Somit hat das erfindungsgemäße Verfahren den Vorteil, daß ein Fügen von Kontaktflächen einer gesonderten Umverdrahtungsplatte auf die Kontaktbereiche des Halbleiterchips in jeder Bauteilposition entfällt. Es muss weder eine Umverdrahtungsplatte bereitgestellt werden, noch ist es erforderlich eine derartige Umverdrahtungsplatte mit elektronischen Bauteilen zu bestücken. Schließlich entfällt auch das Einpressen von Kunststoffeinbettmasse zwischen Umverdrahtungsplatte und Halbleiterchips unter Gefährdung der elektrischen Verbindungen zwischen den Kontaktbereichen des Halbleiterchips und einer Umverdrahtungsplatte.

Zusammenfassend ist festzustellen, dass die erfindungsgemäße Gehäusetechnologie die notwendige Umverdrahtung von den Kontaktbereichen eines Halbleiterchips zu den Außenkontakten eines elektronischen Bauteils nicht durch einen vorgefertigten Zwischenträger erreicht, sondern es werden Umverdrahtungslagen in einem parallelen Prozess auf einem Nutzen Schicht für Schicht aufgebracht. Dazu werden gesägte Halbleiterchips in eine Kunststoffeinbettmasse gedrückt, die mindestens zwei unterschiedliche Vernetzungsgrade aufweist, wobei der Vernetzungsgrad im Bereich der Unterseite der ersten Kunststoffschicht größer ist, als in dem darüber liegenden Bereich der ersten Kunststoffschicht.

Durch das erfindungsgemäße Verfahren wird somit eine zuverlässige Verbindung zwischen Kontaktanschlussflächen einer Umverdrahtungsstruktur und Kontaktbereichen eines Halbleiterchips für elektronische Bauteile bereitgestellt. Bei dem erfindungsgemäßen Verfahren können abschließend auf eine äußere Umverdrahtungslage des Nutzens Außenkontakte in allen Bauteilpositionen aufgebracht werden. Mit diesem Schritt wird gewährleistet, daß über die Außenkontakte die Bauteile des Nutzens bereits einen Funktionstest durchlaufen können, so daß bereits auf dem Nutzen defekte Bauteile markiert werden können.

Zur Herstellung von einzelnen elektronischen Bauteilen wird dann lediglich ein derartiger Nutzen an den Grenzen der Bauteilpositionen zu einzelnen Bauteilen getrennt.

Ein aus einem derartigen Nutzen herausgetrenntes elektronisches Bauteil weist nachfolgende Merkmale auf. Der Halbleiterchip ist in einer mehrschichtigen Kunststoffmasse eingebettet. Zusätzlich ist der Halbleiterchip auf seinen Randseiten bis zu einem Teil seiner Randseitenhöhe von einer ersten Kunststoffschicht umgeben. Diese erste Kunststoffschicht weist eine obenseitige Grenzfläche zu einer darüber liegenden zweiten Kunststoffschicht auf. Diese zweite Kunststoffschicht liegt an Bereichen der Randseiten des Halbleiterchips an, die nicht von der ersten Kunststoffschicht bereits bedeckt sind. Darüber hinaus weist die zweite Kunststoffschicht eine nun ebene Oberseite auf, die eine Grenzfläche zu wenigstens einer weiteren Bauteilebene bildet. Oberhalb der zweiten Kunststoffschicht ist wenigstens eine Umverdrahtungsstruktur mit Durchkontakten zwischen Kontaktbereichen des Halbleiterchips und Außenkontakten des elektronischen Bauteils vorgesehen.

Ein derartiges elektronisches Bauteil hat den Vorteil, daß die Umverdrahtungsstruktur mit den Durchkontakten zu den Kontaktbereichen des Halbleiterchips unmittelbar auf der eingeebneten Oberfläche der zweiten Kunststoffschicht anliegt. Dadurch lässt sich eine zuverlässige Kontaktierung zwischen Umverdrahtungsstruktur und Kontaktbereichen der Halbleiterchips verwirklichen, zumal die Kontaktbereiche der Halbleiterchips des Nutzens vollständig frei liegen und zugänglich sind. Außerdem hat das elektronische Bauteil den Vorteil, dass auf eine derart zuverlässig mit den Kontaktbereichen des Halbleiterchips verbundenen Umverdrahtungsstruktur weitere Umverdrahtungslagen mit zwischengelagerten Isolationslagen aufbringbar sind und somit komplexe Umverdrahtungsstrukturen, die Kreuzungen und Brücken aufweisen können, auf einfachste Weise mit einem derartigen elektronischen Bauteil realisierbar sind.

Erfindungsgemäß wird ein Nutzen mit mehreren Bauteilpositionen für elektronische Bauteile mit jeweils einem Halbleiterchip geschaffen, wobei der Nutzen nachfolgende Merkmale aufweist.

Die in dem Nutzen eingebetteten Halbleiterchips sind auf ihren Randseiten bis zu jeweils einem Teil ihrer Randseitenhöhe von einer ersten Kunststoffschicht umgeben. Diese erste Kunststoffschicht weist eine obenseitige Grenzfläche zu wenigstens einer darüber liegenden zweiten Kunststoffschicht auf. Die zweite Kunststoffschicht liegt an Bereichen der Randseiten der Halbleiterchips an, die nicht von der ersten Kunststoffschicht bereits bedeckt sind. Darüber hinaus weist die zweite Kunststoffschicht eine ebene Oberseite auf, die eine Grenzfläche zu wenigstens einer Umverdrahtungsstruktur bildet. Sowohl oberhalb der zweiten Kunststoffschicht als auch oberhalb der Halbleiterchips sind Außenkontakte elektronischer Bauteile vorgesehen, die über die Umverdrahtungsstruktur mit den Kontaktbereichen der Halbleiterchips verbunden sind. Die erste Kunststoffschicht und/oder die zweite Kunststoffschicht sind mindestens teilweise zu einer selbsttragenden, im wesentlichen formstabilen mehrschichtigen Kunststoffplatte ausgehärtet.

Ein derartiger Nutzen hat den Vorteil, dass die Halbleiterchips in den Bauteilpositionen durch die erste Kunststoffschicht fixiert sind und die zweite Kunststoffschicht eine Ausgleichsschicht zum Einebnen des Nutzens bildet. Zwischen der ersten und der zweiten Kunststoffschicht können noch weitere Kunststoffschichten angeordnet sein. Ein derartiger Nutzen hat darüber hinaus den Vorteil, dass mehrere elektronische Bauteile gleichzeitig mit dem Nutzen entstehen.

Dabei weist sowohl das elektronische Bauteil als auch der Nutzen eine erste Kunststoffschicht auf, die auf einer Kunststoffeinbettmasse basiert, die höhengestaffelt unterschiedliche Vernetzungsgrade aufweist. Dabei ist der höchste Vernetzungsgrad im Bereich einer Grundfläche der ersten Kunststoffschicht angeordnet. Diese Staffelung des Vernetzungsgrades sorgt für eine definierte Positionierung und Fixierung der Halbleiterchips in der ersten Kunststoffschicht beziehungsweise in dem Nutzen auf jeder Bauteilposition.

Die erste Kunststoffschicht kann auf einer Kunststoffeinbettmasse basieren, die einen vollständig vernetzten Bereich im Bereich einer Grundplatte aufweist, und darüber einen vorvernetzten Bereich hat. In diesem Fall bildet der vollständig vernetzte Bereich für den Nutzen eine Montageplatte auf der die Halbleiterchips in definierter Höhe in der ersten Kunststoffschicht angeordnet sind.

Liegt ein solcher vollständig vernetzter unterer Bereich nicht vor, so kann die erste Kunststoffschicht mit kugelförmigen Partikeln insbesondere aus Glas gefüllt sein. Diese kugelförmigen Partikel bilden Abstandshalter für die Halbleiterchips aufgrund ihres einheitlichen vorgegebenen Durchmessers und fixieren die Halbleiterschips auf einer vorgegebenen Höhe in der ersten Kunststoffschicht.

Die zweite Kunststoffschicht kann ein Polyimidharz aufweisen, das den Vorteil hat, dass es durch Photolithographie strukturierbar ist. Somit kann das Bauteil oder der Nutzen durch die zweite Kunststoffschicht aus Polyimidharz gleichmäßig und vollständig bedeckt sein. Die Kontaktbereiche des Halbleiterchips in dem Nutzen können falls sie von der zweiten Kunststoffschicht bedeckt sind, mit einem Photolithographieschritt in dem Polyimidharz freigelegt werden. Die Kunststoffplatte kann mit einer Haftschicht belegt sein, auf der eine Umverdrahtungsstruktur sicher verankert ist. Das Aufbringen einer derartigen Haftschicht kann großflächig erfolgen, solange die Haftschicht sich aus isolierenden Oxiden zusammensetzt.

Je nach Aufbau des elektronischen Bauteils, kann entweder die aktive Oberseite des Halbleiterchips mit ihren Kontaktbereichen oder die passive Rückseite des Halbleiterchips in der ersten Kunststoffschicht angeordnet sein. In beiden Fällen ist ein Zugriff auf die Kontaktbereiche möglich, wobei die Kontaktbereiche entweder aus der Oberseite der ersten Kunststoffschicht herausragen oder mit ihren Kontaktbereichen die erste Kunststoffschicht durchdringen und von der Unterseite der ersten Kunststoffschicht aus zugänglich sind. In beiden Fällen ist der Schritt des Freilegens der Kontaktbereiche der Halbleiterchips zuverlässig und einfach durchführbar.

Zusammenfassend ergeben sich für den Aufbau von einem "waferlevel-package" bzw. von einem Nutzen drei mögliche Varianten für eine "fan-out" Umverdrahtung, bei der Außenkontakte nicht nur oberhalb des Bereichs des Halbleiterchips auf dem Nutzen angeordnet sind, sondern auch außerhalb dieses Bereichs oberhalb der Kunststoffplatte des Nutzen im Bereich der Kunststoffeinbettmasse vorhanden sind. Die drei Varianten für eine "fan-out" Umverdrahtung werden in den anliegenden Figuren näher erläutert.

Mit der ersten Variante wird der Halbleiterchip in ein zweistufiges bzw. "bi-stage"-Material mit seiner passiven Rückseite eingebettet. Diese Variante hat die nachfolgenden Vorteile.
- Die aktive Oberseite des Halbleiterchips muss während des Einbettprozesses nicht abgedichtet werden, und die Kontaktbereiche des Halbleiterchips werden zuverlässig offen gehalten.
- Für den Aufbau des expandierten Wafers ist nur ein einziger Bestückungsprozess notwendig. Der Prozessablauf ist daher wesentlich vereinfacht und kostengünstig realisierbar.
- Für dieses Konzept kann auf erhöhte Kontaktbereiche des Halbleiterchip wie Kontaktköpfe, Kontaktsäulen, Kontaktbälle und Kontakthöcker verzichtet werden.

Bei einer zweiten Variante werden die in einem zweistufigen bzw. "bi-stage"-Material einer ersten Kunststoffschicht fixierten Halbleiterchips in einen anschließendem Transfermoldprozess in der Weise eingebracht, dass ihre passive Rückseite in die ersten Kunststoffschicht eingebettet ist und der Rest der Seitenränder der Halbleiterchips von Kunststoffvergußmasse bedeckt wird. Dabei dient die erste Kunststoffschicht lediglich zum Fixieren der Halbleiterchips, damit sich die Halbleiterchips beim Transfermoldprozess nicht mehr verschieben können. Bei der Herstellung des Trägers kann für diese Variante ein gegossener Träger ohne zusätzliches Unterstützungsmaterial wie einer Folie oder eines festen Trägers verwendet werden. Um die Formstabilität zu gewährleisten kann der Träger in den unteren Bereichen gezielt erhitzt bzw. abgekühlt werden, um einen hohen Vernetzungsgrad zu erreichen. Der obere Bereich der ersten Kunststoffschicht, in der die Halbleiterchips fixiert werden, ist dann lediglich vorvernetzt. Diese zweite Variante hat die nachfolgenden Vorteile.
- Es werden keine verlorenen Träger verwendet. Der Träger kann kostengünstig in einem Moldprozess hergestellt werden.
- Die Positionierung und Fixierung der Halbleiterchips ist einfach.
- Für dieses Konzept kann auf erhöhte Kontaktbereiche der Halbleiterchips verzichtet werden.

Eine dritte Variante platziert die Halbleiterchips mit ihrer aktiven Oberseiten in dem zweistufigen bzw. "bi-stage"-Material der ersten Kunststoffschicht und kann mit einem Transfermoldprozess die passiven Rückseiten der Halbleiterchips freilassen oder sie mit einer Kunststoffgussmasse schützen. Die dritte Variante weist nachfolgende Vorteile auf.
- Wird eine vollständige Einbettung aller Halbleiterchipseiten in das gleiche Material durchgeführt, so wird eine optimale Zuverlässigkeit des Herstellungsprozesses und der elektronischen Bauteile erreicht.
- Die aktive Seite des Halbleiterchips ist beim Einbetten in die erste Kunststoffschicht nicht aufwendig abzudichten.
- Durch die vollständige Einbettung des Halbleiterchips auch oberhalb der aktiven Oberseite des Halbleiterchips wird die Zuverlässigkeit des Aufbaus weiter erhöht, da die Umverdrahtungslagen auf einer einheitlichen Grundfläche aufgebracht werden können. Die weiteren Umverdrahtungs- und Isolationslagen müssen somit nicht bezüglich der Haftung an das Silicium der Halbleiterchips angepaßt werden.
- Die überhöhten Kontakte müssen keine lötfähigen Verbindungen darstellen, da die Halbleiterchips nicht über die Kontakte fixiert werden, sondern über die Kunststoffeinbettmasse der ersten Kunststoffschicht.
- Wird bei dem Transfermoldprozess die Rückseite der Halbleiterchips freigehalten von Kunststoffgussmasse, so kann dort eine zusätzliche Wärmesenke angebracht werden, um eine höhere Verlustleistung beim Betrieb der elektrischen Bauteile ableiten zu können.

Die Erfindung wird nun anhand der beiliegenden Figuren näher erläutert.
- Figur 1: zeigt einen schematischen Querschnitt durch einen Nutzen im Bereich einer Bauteilposition,
- Figuren 2 bis 4: zeigen schematische Querschnitte von Zwischenprodukten bei der Herstellung eines Nutzens gemäß eines ersten Verfahrensbeispiels der Erfindung,

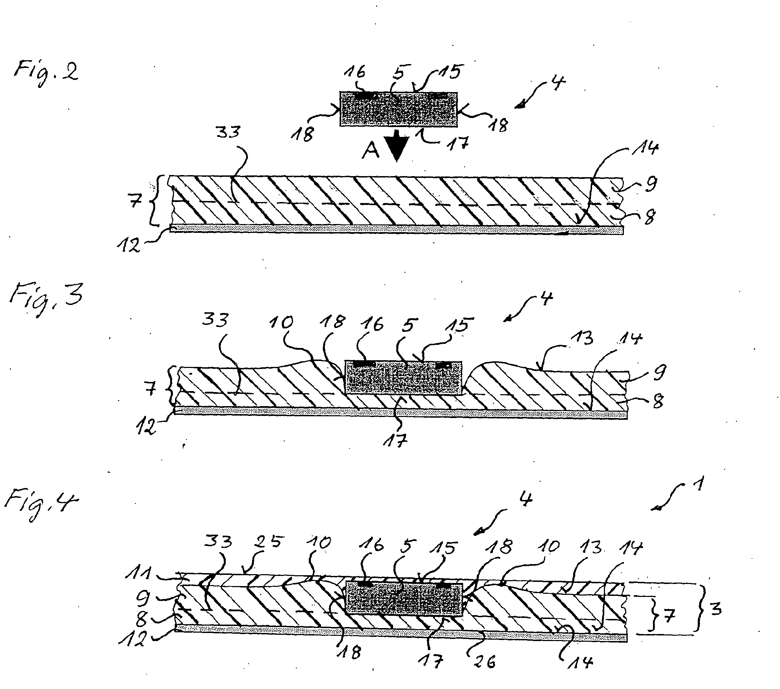

- Figur 2: zeigt einen schematischen Querschnitt durch eine erste Kunststoffschicht, die auf einer Grundplatte angeordnet ist,

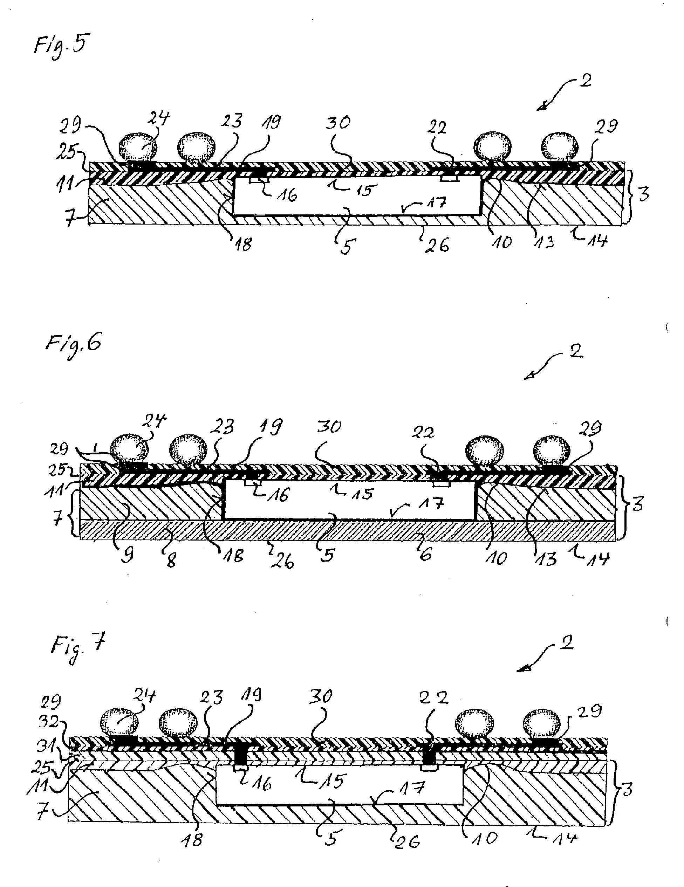

- Figur 3: einen schematischen Querschnitt einer Bauteilposition nach dem Einbetten eines Halbleiterchips in die erste Kunststoffschicht,
- Figur 4: zeigt einen schematischen Querschnitt durch einen Nutzen nach Aufbringen einer zweiten Kunststoffschicht auf den Nutzen,
- Figur 5: zeigt einen schematischen Querschnitt eines elektronischen Bauteils einer ersten Ausführungsform der Erfindung,
- Figur 6: zeigt einen schematischen Querschnitt eines elektronischen Bauteils einer zweiten Ausführungsform der Erfindung,

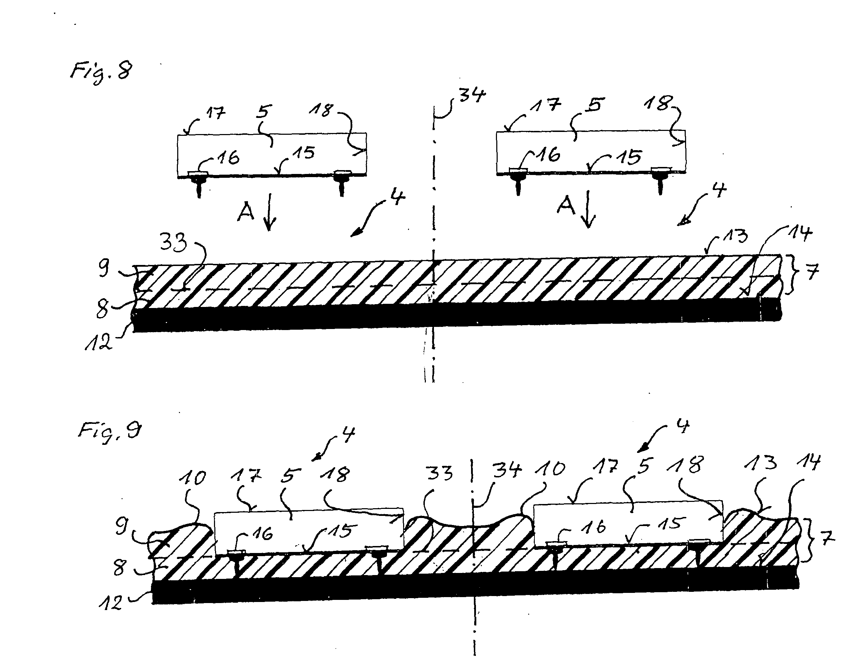

- Figur 7: zeigt einen schematischen Querschnitt eines elektronischen Bauteils einer dritten Ausführungsform der Erfindung,
- Figuren 8 bis 11: zeigen schematische Querschnitte von Zwischenprodukten bei der Herstellung eines Nutzens gemäß eines zweiten Verfahrensbeispiels der Erfindung,
- Figur 8: zeigt einen schematischen Querschnitt durch eine erste Kunststoffschicht auf einer Grundplatte,
- Figur 9: zeigt einen schematischen Querschnitt durch die erste Kunststoffschicht nach einem Einbetten von Halbleiterchips in die erste Kunststoffschicht an Bauteilpositionen des Nutzens,

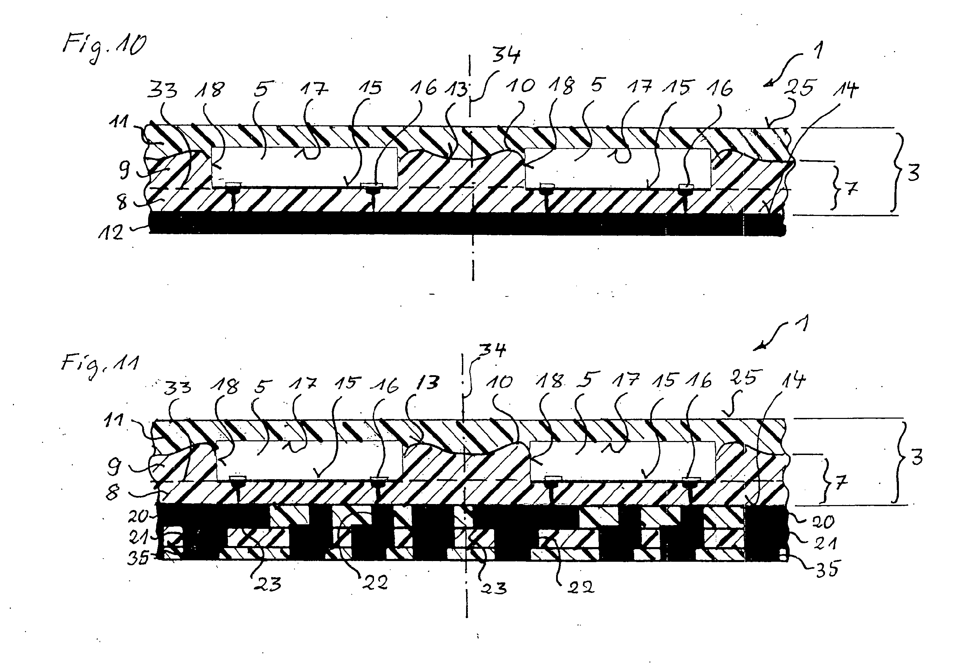

- Figur 10: zeigt einen schematischen Querschnitt durch einen Nutzen nach dem Aufbringen einer zweiten Kunststoffschicht
- Figur 11: zeigt einen schematischen Querschnitt durch einen Nutzen nach einem Aufbringen mehrerer Umverdrahtungslagen auf den Bauteilpositionen des Nutzens.

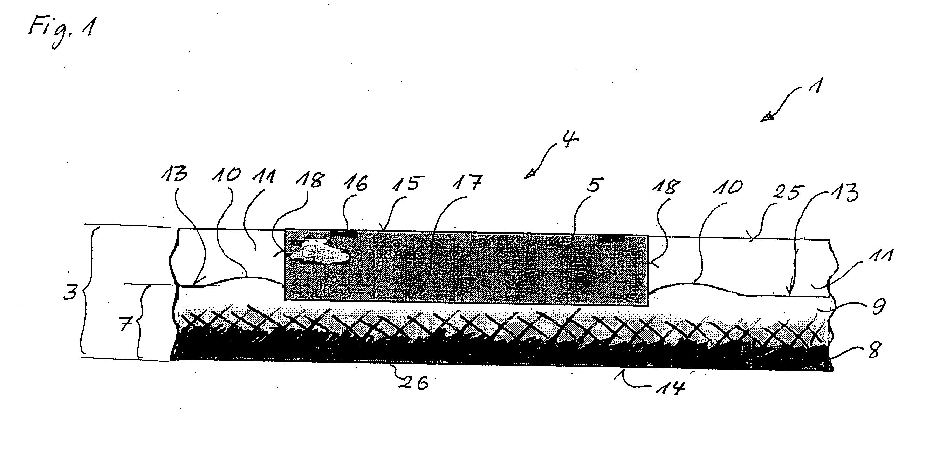

Figur 1 zeigt einen schematischen Querschnitt durch einen Nutzen 1 im Bereich einer Bauteilposition 4. Der Nutzen 1 weist eine selbsttragende formstabile Kunststoffplatte 3 auf, in der an der Bauteilposition 4 ein Halbleiterchip 5 eingebettet ist. Der Halbleiterchip 5 weist eine aktive Oberseite 15 mit Kontaktbereichen 16 und eine passive Rückseite 7 sowie Randseiten 18 auf. Mit seiner passiven Rückseite 17 ist der Halbleiterchip 5 in eine erste Kunststoffschicht 7 eingebettet, die vor einem Aushärten des Nutzens 1 höhengestaffelt Bereiche mit unterschiedlichem Vernetzungsgrad aufweist.

Das für die erste Kunststoffschicht 7 eingesetzte Kunststoffmaterial ist ein sogenanntes "bi-stage"-Material oder zweistufiges Material aus einem Duroplast, wobei ein oberer Bereich 9 der ersten Kunststoffschicht 7 vor einem Aushärten geringer vernetzt ist als ein unterer Bereich 8. Der Vernetzungsgrad des unteren Bereichs 8 ist in dieser ersten Ausführungsform derart hoch, dass bereits eine vollständige Vernetzung vor einem Aushärten der Kunststoffschichten vorliegt. Dieser stark vernetzte untere Bereich 8 bildet eine stabile Grundfläche 26 aus, die gleichzeitig die Grundfläche für die gesamte Kunststoffplatte 3 des Nutzens 1 bildet.

Ein Wulst 10 aus Kunststoffeinbettmasse der ersten Kunststoffschicht 7 umgibt den Halbleiterchip 5 in seinem Randbereich 18. Dieser Wulst 10 bildet sich beim Einbringen des Halbleiterchips 5 mit seiner passiven Rückseite 17 in den oberen Bereich 9 der ersten Kunststoffschicht 7. Der Wulst 10 benetzt die Randseiten 18 in ihren unteren Bereichen und sorgt dafür, dass der Halbleiterchip 5 in der ersten Kunststoffschicht 7 an einer der Bauteilpositionen 4 des Nutzens 1 fixiert ist.

Aufgrund des zunehmenden Vernetzungsgrades der ersten Kunststoffschicht 7 in Richtung auf die Grundfläche 26 ist der Halbleiterchip 5 nicht beliebig tief in die erste Kunststoffschicht 7 mit seiner passiven Rückseite 17 eingedrungen. Die Eindringtiefe des Halbleiterchips 5 in der ersten Kunststoffschicht 7 wird durch den Vernetzungsgrad des unteren Bereichs 8 vor dem Aushärten definiert.

Die Kontaktbereiche 16 auf der aktiven Oberseite 15 des Halbleiterchips 5 bleiben vollständig frei von der Kunststoffeinbettmasse der ersten Kunststoffschicht 7, da der Halbleiterchip 5 mit seiner aktiven Oberseite 15 aus der ersten Kunststoffschicht 7 herausragt. Die von der ersten Kunststoffschicht 7 nicht benetzten Bereiche der Randseiten 18 des Halbleiterchips 5 sind von einer zweiten Kunststoffschicht 11 bedeckt, die eine ebene obenseitige Grenzfläche 25 ausbildet, ohne die aktive Oberseite 15 des Halbleiterchips 5 zu benetzen. Diese zweite Kunststoffschicht 11 bildet eine einebnende Ausgleichsmasse und schließt sich an eine obenseitige Grenzfläche 13 der ersten Kunststoffschicht 7 an. Diese zweite Kunststoffschicht 11 weist in dieser Ausführungsform der Erfindung einen mit Isolationspartikeln gefüllten Duroplast auf, der mit einem Transfermoldverfahren aufgebracht ist. Bei dem Transfermodeverfahren wurde die aktive Oberseite 15 des Halbleiterchips 5 auf eine Dichtfolie einer Spritzgussform gepresst, so dass die gesamte aktive Oberseite 15 des Halbleiterchips 5 von dem Material der zweiten Kunststoffschicht 11 freigehalten ist. Auf der geschaffenen ebenen obenseitigen Grenzfläche 25 der zweiten Kunststoffschicht 11 wird eine hier nicht gezeigte Umverdrahtungsstruktur auf den Nutzen 1 zuverlässig aufgebracht, zumal die Kontaktbereiche 16 der aktiven Oberseite 15 des Halbleiterchips 5 für eine Umverdrahtungsstruktur zugänglich sind. Eine derartige Umverdrahtungsstruktur wird Schicht für Schicht auf den Nutzen 1 aufgebracht.

Figuren 2 bis 4 zeigen schematische Querschnitte von Zwischenprodukten bei der Herstellung eines Nutzens gemäß eines ersten Verfahrensbeispiels der Erfindung. Komponenten mit gleichen Funktionen wie in Figur 1 werden mit gleichen Bezugszeichen in den Figuren 2 bis 4 gekennzeichnet und nicht extra erörtert.

Figur 2 zeigt einen schematischen Querschnitt durch eine erste Kunststoffschicht 7 auf einer Grundplatte 12. Diese erste Kunststoffschicht 7 wird von einer Grundplatte 12 aus einer Metalllegierung getragen und weist in ihrem unteren Bereich 8 einen Vorvernetzungsgrad auf der größer als in ihrem oberen Bereich 9 ist. Außerdem weist die erste Kunststoffschicht 7 eine Füllung mit Glaskugeln auf, die einen einheitlichen Durchmesser aufweisen. Dieser Durchmesser der Glaskugel liegt bei wenigen hundert Nanometern, wobei die Glaskugeln mittels eines Sprühverfahrens hergestellt sind. Der Füllgrad dieser ersten Kunststoffschicht mit kugelförmigen Partikeln liegt zwischen 5 und 50 Gew.%. Mit diesem geringen Füllgrad wird erreicht, dass beim Eindringen in Pfeilrichtung A des Halbleiterchips 5, der an der Bauteilposition 4 oberhalb der ersten Kunststoffschicht 7 ausgerichtet ist, eine definierte Eindringtiefe für den Halbleiterchip 5 gewährleistet ist. Die kugelförmigen Partikel mit einheitlichem Durchmesser bilden dabei Abstandshalter zu der in Figur 2 gezeigten Grundplatte 12. Damit wird ein Abstand von nur wenigen hundert Nanometern zwischen der Unterseite 14 der ersten Kunststoffschicht 7 und der passiven Rückseite 17 des Halbleiterchips 5 beim Eindringen des Halbleiterchips 5 in Pfeilrichtung A gewährleistet.

Figur 3 zeigt einen schematischen Querschnitt einer Bauteilposition 4 nach dem Einbetten eines Halbleiterchips 5 in der ersten Kunststoffschicht 7. Dabei wird der Halbleiterchip 5 bis auf einen definierten Abstand zur Grundplatte 12 in die erste Kunststoffschicht 7 eingebracht, wobei sich ein Wulst 10 aus gering vernetztem Material des oberen Bereichs 9 der ersten Kunststoffschicht 7 ausbildet. Die dabei entstehende obenseitige Grenzfläche 13 der ersten Kunststoffschicht 7 ist uneben und nicht für ein Aufbringen von Umverdrahtungsstrukturen geeignet. Jedoch werden mit dem Eindringen der passiven Rückseite 17 des Halbleiterchips 5 in die erste Kunststoffschicht 7 die Randseiten 18 des Halbleiterchips 5 in einem unteren Bereich benetzt, so dass der Halbleiterchip 5 in dieser Bauteilpositionen 4 fixiert bleibt. Ein Verschieben des Halbleiterchips 5 aus der Bauteilpositionen 4 bei nachfolgenden Verfahrensschritten wird dadurch verhindert.

Figur 4 zeigt einen schematischen Querschnitt durch einen Nutzen 1 nach Aufbringen einer zweiten Kunststoffschicht 11 auf die obenseitige Grenzfläche 13 der ersten Kunststoffschicht 7. In diesem ersten Durchführungsbeispiel des Verfahrens weist die zweite Kunststoffschicht 11 ein Polyimidharz auf, das vollständig die aktive Oberseite 15 des Halbleiterchips 5 bedeckt. Das Polyimidharz wird in dieser Ausführungsform der Erfindung gleichzeitig als Photolackschicht verwendet. Mit Hilfe eines Photolithographieschrittes werden aufgrund der photoempfindlichen Eigenschaften des Polyimidharzes Kontaktbereiche 16 des Halbleiterchips 5 freigelegt. Das Polyimidharz bildet in diesem ersten Ausführungsbeispiel des Verfahrens eine vollständig eingeebnete obenseitige Grenzfläche 25. Dazu wird für die zweite Kunststoffschicht 11 ein Schleuderverfahren eingesetzt. Auf der eingeebneten Grenzfläche 25 werden dann weitere Verfahrensschritte für mehrere elektronische Bauteile gleichzeitig durchgeführt.

Figur 5 zeigt einen schematischen Querschnitt eines elektronischen Bauteils 2 einer ersten Ausführungsform der Erfindung. Komponenten mit gleichen Funktionen wie in vorhergehenden Figuren sind mit gleichen Bezugszeichen gekennzeichnet und werden nicht extra erörtert.

Der Nutzen, aus dem dieses elektronische Bauteil 2 der Figur 5 ausgetrennt wurde, ist mit einem Verfahren hergestellt, das mit Bezug auf die Figuren 2 bis 4 oben erläutert wurde. Dazu ist die in Figur 4 gezeigte metallische Grundplatte 12 vor dem Trennen des Nutzens in einzelne elektronische Bauteile 2 von der Kunststoffplatte des Nutzens entfernt worden. Außerdem sind in der zweite Kunststoffschicht 11 mit einem photolithographischen Schritt Fenster geöffnet worden, in denen die Kontaktbereiche 16 des Halbleiterchips 5 von der zweiten Kunststoffschicht 11 freigelegt sind.

Auf der zweiten Kunststoffschicht 11 ist eine Umverdrahtungsstruktur 19 angeordnet, die Durchkontakte 22 zu den Kontaktbereichen 16 der aktiven Oberseite 15 des Halbleiterchips 5 aufweist. Die Kontaktbereiche 16 sind als Flächenkontakte ausgebildet. Die Umverdrahtungsstruktur 19, die auf der Kunststoffschicht 11 in einem chemischen Verfahren abgeschieden wurde, weist Umverdrahtungsleitungen 23 auf, die von den Durchkontakte 22 zu Außenkontaktflächen 29 führen. Diese Außenkontaktflächen 29 sind außerhalb des Bereichs des Halbleiterchips 5 auf der Kunststoffplatte 3 angeordnet und tragen Außenkontakte 24 in Form von Lötbällen. Eine derartige Anordnung der Außenkontakte 24 wird auch als "fan-out" bezeichnet. Eine Lötstopplackschicht 30, welche die Außenkontakte 25 umgibt, schützt die Umverdrahtungsleitungen 23 der Umverdrahtungsstruktur 19 vor einem Benetzen mit Fügematerial beim Fügen der Außenkontakte 24 auf den Außenkontaktflächen 29.

Anstelle der einlagigen Umverdrahtungsstruktur 19 sind in einem hier nicht gezeigten Beispiel eines elektronischen Bauteils 2 mehrlagige Umverdrahtungsstrukturen vorgesehen. Dazu werden Schicht für Schicht nacheinander Umverdrahtungslagen auf die eingeebnete zweite Kunststoffschicht 11 aufgebracht.

Figur 6 zeigt einen schematischen Querschnitt eines elektronischen Bauteils 2 einer zweiten Ausführungsform der Erfindung. Komponenten mit gleichen Funktionen wie in den vorhergehenden Figuren werden mit gleichen Bezugszeichen gekennzeichnet und nicht extra erörtert.

Die zweite Ausführungsform der Erfindung unterscheidet sich von der in Figur 5 gezeigten ersten Ausführungsform der Erfindung dadurch, dass der untere Bereich 8 der ersten Kunststoffschicht 7 vollständig vernetzt ist, so dass sich eine Trägerplatte aus Kunststoff ausbildet. Eine metallische Grundplatte ist zur Herstellung eines derartigen elektronischen Bauteils 2 im Gegensatz zu dem elektronischen Bauteil 2 der ersten Ausführungsform nicht erforderlich. Der vollständig vernetzte untere Bereich 8 bildet eine selbsttragende formstabile Grundlage, auf welcher der Halbleiterchip 5 ausgerichtet und angeordnet ist. Der obere Bereich 9 der ersten Kunststoffschicht 7 ist zunächst vor einem Aushärten der Kunststoffschichten 7 und 11 nur vorvernetzt, so daß sich beim Eindringen des Halbleiterchips 5 in die erste Kunststoffschicht 7 ein Wulst 10 rund um die Randseiten 18 des Halbleiterchips 5 ausgebildet. Die zweite Kunststoffschicht 11 ist als Ausgleichsmasse auf der obenseitigen Grenzfläche 13 der ersten Kunststoffschicht 7 angeordnet. Diese zweite Kunststoffschicht 11 bildet eine ebene obenseitige Grenzfläche 25 aus, auf der eine Lötstopplackschicht 30 angeordnet ist. Die Anordnung und Struktur der Außenkontaktflächen und der Außenkontakte entspricht der in Figur 5 gezeigten ersten Ausführungsform.

Figur 7 zeigt einen schematischen Querschnitt eines elektronischen Bauteils 2 einer dritten Ausführungsform der Erfindung. Komponenten mit gleichen Funktionen wie in den vorhergehenden Figuren werden mit gleichen Bezugszeichen gekennzeichnet und nicht extra erörtert.

Der Halbleiterchip 5 des elektronischen Bauteils 2 der dritten Ausführungsform der Erfindung ist auch mit seiner passiven Rückseite 17 in der ersten Kunststoffschicht 7 fixiert. Die dritte Ausführungsform des elektronischen Bauteils 2 unterscheidet sich von den ersten beiden Ausführungsformen, die in den Figur 5 und 6 gezeigt sind, dadurch, dass die Kontaktbereiche 16 des Halbleiterchips 5 keine Flächenkontakte aufweisen. Vielmehr ist die Umverdrahtungsstruktur 19 mit Kontaktbereichen 16 des Halbleiterchips 5 elektrisch verbunden, die überhöhte Flipchip-Kontakte in Form von Kontaktbällen, Kontakthöckern, Kontaktsäulen oder Kontaktköpfen aufweisen. Zum Ausgleich der Höhe dieser Flipchip-Kontakte ist eine Isolationsschicht 31 auf die obenseitige Grenzfläche 25 der zweiten Kunststoffschicht 11 aufgebracht. Auf der Isolationsschicht 31 ist eine weitere Isolationsschicht 32 mit Durchkontakten 22 angeordnet. Auf dieser weiteren Isolationsschicht 32 ist eine Umverdrahtungsstruktur 19 angeordnet, die mit den Durchkontakten 22 elektrisch verbunden ist. Die Anordnung und Struktur der Außenkontaktflächen 29 und der Außenkontakte 24 entspricht der in den Figuren 5 und 6 gezeigten Ausführungsformen.

Während in den drei obigen Ausführungsformen des elektronischen Bauteils 2 und in dem ersten Verfahrensbeispiel zur Herstellung eines derartigen elektronischen Bauteils 2 der Halbleiterchip 5 mit seiner passiven Rückseite 17 in der ersten Kunststoffschicht 7 aus einem zweistufigen Material bzw. "bi-stage"-Material fixiert ist, wird mit den Figuren 8 bis 11 ein zweites Durchführungsbeispiel des Verfahrens erläutert, bei dem Halbleiterchips 5 mit ihrer aktiven Oberseiten 15 in der ersten Kunststoffschicht eingebettet werden.

Die Figuren 8 bis 11 zeigen schematische Querschnitte von Zwischenprodukten bei der Herstellung eines Nutzen 1 gemäß eines zweiten Verfahrensbeispiels der Erfindung. Komponenten mit gleichen Funktionen wie in den vorhergehenden Figuren werden in den Figuren 8 bis 11 mit gleichen Bezugszeichen gekennzeichnet und nicht extra erörtert.

Der wesentliche Aspekt, der das mit den Figuren 8 bis 11 gezeigte zweite Durchführungsbeispiel des Verfahrens von dem mit den Figuren 2 bis 4 gezeigten ersten Durchführungsbeispiel unterscheidet, besteht darin, dass in dem zweiten Durchführungsbeispiel die Halbleiterchips 5 an den Bauteilpositionen 4 in die erste Kunststoffschicht 7 aus einem zweistufigen Material mit ihren aktiven Oberseiten 15 in dieses Material eingebracht werden.

Figur 8 zeigt einen schematischen Querschnitt durch eine erste Kunststoffschicht 7 auf einer Grundplatte 12. Die erste Kunststoffschicht 7 weist einen unteren Bereich 8 auf, der stärker vernetzt ist als ein oberer Bereich 9. Die gestrichelte Linie 33 gekennzeichnet den Übergang von dem stärker vernetzten unteren Bereich 8 zu dem weniger stark vernetzten oberen Bereich 9. Eine in Figur 8 vertikale strichpunktierte Linie 34 kennzeichnet die Grenze zwischen zwei Bauteilpositionen 4, über denen jeweils ein Halbleiterchip 5 derart ausgerichtet ist, dass er in Pfeilrichtung A mit seiner aktiven Oberseite 15 und den Kontaktbereichen 16 in die erste Kunststoffschicht 7 eingebracht werden kann.

Aufgrund ihres vorvernetzten Zustandes ist die Kunststoffschicht 7 bei Raumtemperatur fest und erreicht einen teilviskosen Zustand in dem stärker vernetzten unteren Bereich 8 und einen Zustand mit geringerer Viskosität in dem oberen Bereich 9 bei einem Erwärmen der ersten Kunststoffschicht 7 auf Temperaturen zwischen 90 und 120 °C. Nach dem Erwärmen der ersten Kunststoffschicht 7 auf eine derartige Temperatur werden die Halbleiterchips 5 mit ihren aktiven Oberseiten 15 in Pfeilrichtung A in die erste Kunststoffschicht 7 eingebracht.

Figur 9 zeigt einen schematischen Querschnitt durch die erste Kunststoffschicht 7 nach einem Einbetten der Halbleiterchips 5 in die erste Kunststoffschicht 7 an den Bauteilpositionen 4 des Nutzens. Dabei bildet sich ein Wulst 10 in dem oberen Bereich 9 der ersten Kunststoffschicht 7 aus, der jeden Halbleiterchip 5 in seinen Randbereichen 18 umgibt und somit den Halbleiterchip 5 in der Bauteilpositionen 4 des Nutzens fixiert. Bei dem Einbringen der Halbleiterchips 5 in die erste Kunststoffschicht 7 berühren die Kontaktbereiche 16 der Halbleiterchips 5 die Grundplatte 12. Durch ein weiteres Aufheizen der ersten Kunststoffschicht 7 auf Temperaturen zwischen 120 °C und 350°C für 2 Minuten bis 30 Minuten wird die erste Kunststoffschicht 7 vollständig vernetzt und bildet eine obenseitige Grenzfläche 13 aus.

Figur 10 zeigt einen Querschnitt durch einen Nutzen 1 nach dem Aufbringen einer zweiten Kunststoffschicht 11. Im Gegensatz zu dem ersten Durchführungsbeispiel des Verfahrens, das mit den Figuren 2 bis 4 erläutert wurde, bedeckt die zweite Kunststoffschicht 11 nicht die aktiven Oberseiten 15 der Halbleiterchips 5, sondern die passiven Rückseiten 17 der Halbleiterchips 5. Damit werden die passiven Rückseiten 17 vor mechanischen Beschädigungen geschützt.

In einem hier nicht gezeigten weiteren Durchführungsbeispiel des Verfahrens wird die zweite Kunststoffschicht 11 unter Freilassung der passiven Rückseiten 17 der Halbleiterchips 5 aufgebracht. In diesem Fall besteht die Möglichkeit Wärmesenken unmittelbar auf den passiven Rückseiten 17 der Halbleiterchips 5 aufzubringen, um nach Fertigstellung der elektronischen Bauteile Verlustwärme beim Betrieb abzuführen.

Figur 11 zeigt einen schematischen Querschnitt durch einen Nutzen 1 nach dem Aufbringen mehrerer Umverdrahtungslagen 20, 21 und 35 auf den Nutzen 1 in den Bauteilpositionen 4. Vor einem derartigen Aufbringen von mehreren Umverdrahtungslagen 20, 21 und 35 wird die in Figur 10 gezeigte metallische Grundplatte 12 von dem Nutzen 1 entfernt. Dieses Entfernen der metallischen Grundplatte wird mittels Ätztechnik durchgeführt. Bei entsprechender Oberflächenpräparation der Grundplatte, wird diese auch von der Kunststoffplatte 3 des Nutzens 1 unter Freigeben der Kontaktbereiche 16 der Halbleiterchips 5 abgezogen. Dazu weist die Oberfläche der in Figur 10 gezeigten Grundplatte 12 eine wenige 100 Nanometer dünne Beschichtung beispielsweise aus Polytetrafluorethylen auf.

Wie Figur 11 zeigt, lassen sich mit dem erfindungsgemäßen Verfahren komplexe Umverdrahtungsstrukturen aus mehreren Umverdrahtungslagen 20, 21 und 35 auf der Kunststoffplatte 3 des Nutzens 1 für mehrere elektronische Bauteile gleichzeitig realisieren. Nach Fertigstellung der Umverdrahtungslagen 20, 21 und 35 werden hier nicht gezeigte Außenkontakte auf die äußere Umverdrahtungslage 35 aufgebracht. Der Nutzen 1 wird dann entlang der strichpunktierten Linie 34 in einzelne elektronische Bauteile getrennt.

## Patentansprüche

1. Verfahren zur Herstellung eines Nutzens (1) mit mehreren Bauteilpositionen (4) für elektronische Bauteile (2), wobei der Nutzen (1) eine selbsttragende formstabile Kunststoffplatte (3) aufweist, in der in jeder Bauteilposition (4) ein Halbleiterchip (5) eingebettet ist, und wobei das Verfahren folgende Verfahrensschritte aufweist:
a) Herstellen einer Trägerplatte (6) und/oder einer ersten Kunststoffschicht (7) aus einer Kunststoffmasse die in einem unteren Bereich (8) stärker vernetzt ist als in einem oberen Bereich (9),
b) Aufbringen jeweils eines Halbleiterchips (5) in den Bauteilpositionen (4) des Nutzens (1) unter Bilden eines die Randseiten (18) des Halbleiterchips (5) umgebenden Wulstes (10) aus Kunststoffmasse der ersten Kunststoffschicht (7),
c) Aufbringen einer zweiten Kunststoffschicht (11) und
d) Bilden einer selbsttragenden formstabilen Kunststoffplatte (3) mit eingebetteten Halbleiterchips (5) durch Aushärten der Kunststoffschichten (7, 11).

2. Verfahren nach Anspruch 1,
**dadurch gekennzeichnet, dass**
beim Herstellen einer Trägerplatte (6) eine auf 120 bis 350 °C aufgeheizte Grundplatte (12) mit der ersten Kunststoffschicht (7) aus einer Kunststoffmasse beschichtet wird, die beim Abkühlen der Trägerplatte (6) mit erster Kunststoffschicht (7) einen zu einer obenseitigen Grenzfläche (13) der ersten Kunststoffschicht (7) hin abnehmenden Vernetzungsgrad ausbildet.

3. Verfahren nach Anspruch 1,
**dadurch gekennzeichnet, dass**
beim Herstellen einer Trägerplatte (6) aus einem Vollkunststoff eine erste Kunststoffschicht (7) einer unvernetzten Kunststoffeinbettmasse einem Temperaturgradienten ausgesetzt wird, wobei innerhalb der ersten Kunststoffschicht (7) ein zu obenseitigen Grenzfläche (13) der ersten Kunststoffschicht (7) hin abnehmender Vernetzungsgrad ausgebildet wird, und wobei zur Unterseite (14) in ersten Kunststoffschicht (7) hin ein erster vollständig vernetzter selbstragender formstabiler unterer Bereich (8) hergestellt wird.

4. Verfahren nach einem der vorhergehenden Ansprüche,
**dadurch gekennzeichnet, dass**
eine unvernetzte Kunststoffeinbettmasse für die Herstellung der ersten Kunststoffschicht (7) mit kugelförmigen Partikeln von einheitlichem Kugeldurchmesser insbesondere Glaskugeln gefüllt wird.

5. Verfahren nach einem der vorhergehenden Ansprüche,
**dadurch gekennzeichnet, dass**
beim Aufbringen jeweils eines Halbleiterchips (5) in den Bauteilpositionen (4) des Nutzens der Halbleiterchip (5) mit seiner aktiven Oberseite (15) und den darauf angeordneten Kontaktbereichen (16) zunächst in den erste Kunststoffschicht (7) unter Bilden eines die Randseiten (18) des Halbleiterchips (5) umgebenden Wulstes (10) aus Kunststoffmasse der ersten Kunststoffschicht (7) eingedrückt wird, bis seine Kontaktbereiche (16) eine Trägerpatte (6) aus Metall berühren, und anschließend die passive Rückseite (17) des Halbleiterchips (5) von der zweiten Kunststoffschicht (11) bedeckt wird.

6. Verfahren nach einem der Ansprüche 1 bis 4,
**dadurch gekennzeichnet, dass**
beim Aufbringen jeweils eines Halbleiterchips (5) in den Bauteilpositionen (4) des Nutzens (1) der Halbleiterchip (5) mit seiner passiven Rückseite (17) zunächst in die erste Kunststoffschicht (7) unter Bilden eines die Randseiten (18) des Halbleiterchips (5) umgebenden Wulstes (10) aus Kunststoffmasse der ersten Kunststoffschicht (7) eingedrückt wird, und wobei anschließend die zweite Kunststoffschicht (11) unter Freilassung mindestens der Kontaktbereiche (16) des Halbleiterchips (5), vorzugsweise unter Freilassung der gesamten aktiven Oberseite (15) des Halbleiterchips (5) den Nutzen (1) einebnet.

7. Verfahren nach einem der vorhergehenden Ansprüche,
**dadurch gekennzeichnet, dass**
nach dem Aufbringen der zweiten Kunststoffschicht (11) die Kunststoffmasse beider Kunststoffschichten (7, 11) unter Aufheizen vollständig vernetzt werden.

8. Verfahren nach einem der Ansprüche 1 bis 6,
**dadurch gekennzeichnet, dass**
nach dem Aufbringen jeweils eines Halbleiterchips (5) in den Bauteilpositionen (4) des Nutzens (1) in die erste Kunststoffschicht (7), die erste Kunststoffschicht (7) unter Aufheizen vollständig vernetzt wird.

9. Verfahren nach einem der vorhergehenden Ansprüche,
**dadurch gekennzeichnet, dass**
die zweite Kunststoffschicht (11) auf eine vollständig vernetzte erste Kunststoffschicht (7) mittels eines Transfermoldverfahrens aufgebracht wird.

10. Verfahren nach einem der Ansprüche 1 bis 8,
**dadurch gekennzeichnet, dass**
die zweite Kunststoffschicht (11) auf eine vollständig vernetzte erste Kunststoffschicht (7) mittels eines Schleudergussverfahrens aufgebracht wird.

11. Verfahren nach einem der vorhergehenden Ansprüche,
**dadurch gekennzeichnet, dass**
zum Aushärten der zweite Kunststoffschicht (11) der Nutzen (1) auf 120 bis 350 °C für 2 bis 30 Minuten erwärmt wird.

12. Verfahren nach einem der vorhergehenden Ansprüche,
**dadurch gekennzeichnet, dass**
zum Aushärten der zweiten Kunststoffschicht (11) der Nutzen (1) für einige Sekunden bis zu einigen Minuten mit UV-Licht bestrahlt wird.

13. Verfahren nach einem der vorhergehenden Ansprüche,
**dadurch gekennzeichnet, dass**
auf die selbsttragende formstabile Kunststoffplatte (3) in jeder Bauteilposition (4) eine Umverdrahtungsstruktur (19) aufgebracht wird, die mit Kontaktbereichen (16) in des Halbleiterchips (5) elektrisch verbunden ist.

14. Verfahren nach einem der vorhergehenden Ansprüche,
**dadurch gekennzeichnet, dass**
ein Freilegen der Kontaktbereiche (16) der Halbleiterchips (5) eines Nutzens (1) mittels eines photolithographischen Schrittes erfolgt.

15. Verfahren nach einem der vorhergehenden Ansprüche,
**dadurch gekennzeichnet, dass**
das Aufbringen der Umverdrahtungsstruktur (19) mittels chemischer oder galvanischer Abscheidung eines Metalls erfolgt.

16. Verfahren nach Anspruch 15,
**dadurch gekennzeichnet, dass**
das Aufbringen der Umverdrahtungsstruktur (19) mittels galvanischer Abscheidung in drei Stufen erfolgt, indem zunächst eine geschlossene Metallschicht mittels Sputtern aufgebracht wird, anschließend eine Photolackmaske unter Freilassung der gesputterten Schicht in einem Muster der Umverdrahtungsstruktur (19) aufgebracht wird, und schließlich auf der freigelassenen Struktur galvanisch Metall unter Bildung der Umverdrahtungsstruktur (19) abgeschieden wird, wobei nach der Bildung der Umverdrahtungsstruktur (19) die Photolackschicht und die gesputterte Schicht entfernt werden.

17. Verfahren nach einem der Ansprüche 1 bis 14,
**dadurch gekennzeichnet, dass**
das Aufbringen der Umverdrahtungsstruktur (19) mittels Drucktechnik erfolgt.

18. Verfahren nach einem der vorhergehenden Ansprüche,
**dadurch gekennzeichnet, dass**
weitere Umverdrahtungslagen (20, 21) auf der Kunststoffplatte (3) angeordnet werden, indem im Wechsel Isolationslagen mit Durchkontakten (22) und Isolationslagen mit Umverdrahtungsleitungen (23) auf der mindestens einen Umverdrahtungsstruktur (19) angeordnet werden.

19. Verfahren nach einem der vorhergehenden Ansprüche,
**dadurch gekennzeichnet, dass**
Außenkontakte (24) auf eine äußere Umverdrahtungslage (21) des Nutzens (1) aufgebracht werden.

20. Verfahren zur Herstellung eines elektronischen Bauteils (2), bei dem mit einem Verfahren gemäß einem der Verfahrensansprüche 1 bis 19 ein Nutzen (1) hergestellt wird, wobei weiterhin der Schritt des Vereinzelns von Bereichen des Nutzens (1) an Bauteilposition (4) vorgesehen ist.

21. Elektronisches Bauteil mit einem Halbleiterchip (5), wobei das elektronische Bauteil (2) die folgenden Merkmale aufweist:
- der Halbleiterchip (5) ist in einer mehrschichtigen Kunststoffeinbettmasse eingebettet,
- der Halbleiterchip (5) ist auf seinen Randseiten (18) bis zu einem Teil seiner Höhe von einer ersten Kunststoffschicht (7) umgeben,
- die erste Kunststoffschicht (7) weist eine obenseitige Grenzfläche (13) zu einer darüber liegenden zweiten Kunststoffschicht (11) auf,
- die zweite Kunststoffschicht (11) liegt an Bereichen der Randseiten (18) des Halbleiterchips (5) an, die nicht von der ersten Kunststoffschicht (7) bedeckt sind,
- die zweite Kunststoffschicht (11) weist eine ebene Oberseite auf, die eine Grenzfläche (25) zu wenigstens einer weiteren Bauteilebene aufweist,
- oberhalb der zweiten Kunststoffschicht (11) ist wenigstens eine Umverdrahtungsstruktur (19) mit Durchkontakten (22) zwischen Kontaktbereichen (16) des Halbleiterchips (5) und Außenkontakten (24) des elektronischen Bauteils (2) vorgesehen.

22. Nutzen mit mehreren Bauteilpositionen (4) für elektronische Bauteile (2) mit jeweils wenigstens einem Halbleiterchip (5), wobei der Nutzen (1) die folgenden Merkmale aufweist:
- die Halbleiterchips (5) sind auf ihren Randseiten (18) bis zu jeweils einem Teil ihrer Höhe von einer ersten Kunststoffschicht (7) umgeben,
- die erste Kunststoffschicht (7) weist eine obenseitige Grenzfläche (13) zu wenigstens einer darüber liegenden zweiten Kunststoffschicht (11) auf,
- die zweite Kunststoffschicht (11) liegt an Bereichen der Randseiten (18) der Halbleiterchips (5) an, die nicht von der ersten Kunststoffschicht (7) bedeckt sind,
- die zweite Kunststoffschicht (11) weist eine ebene Oberseite auf, die eine Grenzfläche (25) zu wenigstens einer weiteren Bauteilebene bildet,
- oberhalb der zweiten Kunststoffschicht (11) und/oder oberhalb der Halbleiterchips (5) sind Umverdrahtungsstrukturen (19) mit Durchkontakten (22) zwischen Kontaktbereichen (16) der Halbleiterchips (5) und Außenkontakten (24) elektronischer Bauteile (2) vorgesehen,
- die erste Kunststoffschicht (7) und/oder die zweite Kunststoffschicht (11) sind wenigstens teilweise zu einer selbststragenden, im wesentlichen formstabilen, mehrschichtigen Kunststoffplatte (3) ausgehärtet.

23. Elektronisches Bauteil oder Nutzen nach Anspruch 21 oder Anspruch 22,
**dadurch gekennzeichnet, dass**
die erste Kunststoffschicht (7) auf einer Kunststoffeinbettmasse basiert, die höhengestaffelt unterschiedliche Vernetzungsgrade aufweist, wobei der höchste Vernetzungsgrad im Bereich (8) einer Grundfläche (26) der ersten Kunststoffschicht (7) angeordnet ist.

24. Elektronisches Bauteil oder Nutzen nach einem der Ansprüche 21 bis 23,
**dadurch gekennzeichnet, dass**
die erste Kunststoffschicht (7) auf einer Kunststoffeinbettmasse basiert, die einen vollständig vernetzten Bereich in dem Bereich (8) einer Grundplatte (12) und darüber einen vorvernetzten Bereich (9) aufweist.

25. Elektronisches Bauteil oder Nutzen nach einem der Ansprüche 21 bis 24,
**dadurch gekennzeichnet, dass**
die erste Kunststoffschicht (7) kugelförmige Partikel insbesondere aus Glas aufweist, die als Abstandshalter für die Halbleiterchips (5) in der ersten Kunststoffschicht (7) einen einheitlichen vorgegebenen Durchmesser aufweisen.

26. Elektronisches Bauteil oder Nutzen nach einem der Ansprüche 21 bis 25,
**dadurch gekennzeichnet, dass**
die zweite Kunststoffschicht (11) als einebnende Ausgleichsmasse ein Polyimidharz aufweist.

27. Elektronisches Bauteil oder Nutzen nach einem der Ansprüche 21 bis 26,
**dadurch gekennzeichnet, dass**
die Umverdrahtungsstruktur (19) eine Haftschicht auf den Grenzflächen zu der Kunststoffplatte (3) aufweist.

28. Elektronisches Bauteil oder Nutzen nach einem der Ansprüche 21 bis 27,
**dadurch gekennzeichnet, dass**
die Halbleiterchips (5) mit ihren aktiven Oberseiten (15) in der ersten Kunststoffschicht (7) eingebettet sind und ihre passiven Rückseiten (17) von der zweiten Kunststoffschicht (11) bedeckt sind.

29. Elektronisches Bauteil oder Nutzen nach einem der Ansprüche 21 bis 27 ,
**dadurch gekennzeichnet, dass**
die Halbleiterchips (5) mit ihren aktiven Oberseiten (15) aus der ersten Kunststoffschicht (7) herausragenden, und wobei ihre passiven Rückseiten (17) in der ersten Kunststoffschicht (7) eingebettet sind.
